# EUROPEAN PATENT APPLICATION

(11) **EP 0 610 631 A1**
(43) Date of publication of application: **17.08.1994**
(21) Application number: 93310547.0
(22) Date of filing: 24.12.1993
(51) Int. Cl.: H01L 23/498, H05K 1/11

(54) **Electrical connector**

(30) Priority: 28.12.1992 US 996991
(71) Applicant: AT&T GLOBAL INFORMATION SOLUTIONS INTERNATIONAL INC., Dayton, Ohio 45479 (US); HYUNDAI ELECTRONICS AMERICA, Milpitas, California 95035 (US); SYMBIOS LOGIC INC., Fort Collins, Colorado 80525 (US)
(72) Inventor: Crafts, Harold S., Colorado Springs, CO 80919 (US); Thornberg, Gary R., Colorado Springs, CO 80906 (US)
(74) Representative: Gill, David Alan

(57) **Abstract**

An electrical connector for connecting an integrated circuit (IC) to a receptacle such as a socket includes a base module to which is attached an IC module. The base module contains, on one surface, pins for insertion into the socket, and, on another surface, base pads, which are connected to the pins by conductors located inside the base module. A custom IC module is then formed on the base module. The base pads connect electrically with respective larger pads in the IC module to ensure good electrical contact despite size variations which may exist in the base module. The IC module contains IC pads on an external surface, which connect with the base pads by way of internal interconnections constructed into the IC module. An integrated circuit (IC) is bonded to the IC pads. The base module is formed from a ceramic material and the IC module is formed from a polymer material, such as polyimide.

## Description

This invention relates to electrical connectors of the kind for connecting an integrated circuit to a receptacle such as a socket. The invention also relates to a method of manufacturing such an electrical connector.

One type of such an electrical connector is a Multi-Chip Module (MCM). Multi-Chip Modules (MCMs) are generally constructed from stacks of sheets of thin ceramic material, which are termed "green tape ceramic" because of their appearance. A simplified sequence of the construction is the following:
- Conductive traces are applied to the ceramic sheets. The ceramic sheets can be extremely thin and delicate. Sheets as thin as 127 microns (5 mils) are used.
- Holes are punched in the sheets at proper locations.
- The holes are filled with a tungsten-based paste, which later forms conductive plugs which extend through the sheets.
- The sheets are aligned and stacked, compressed, and fired in an oven, which sinters the assembly. The firing bonds the sheets together, and fuses the tungsten. The fused tungsten forms plugs (or "vias") which extend through the sheets, connecting the conductive traces.

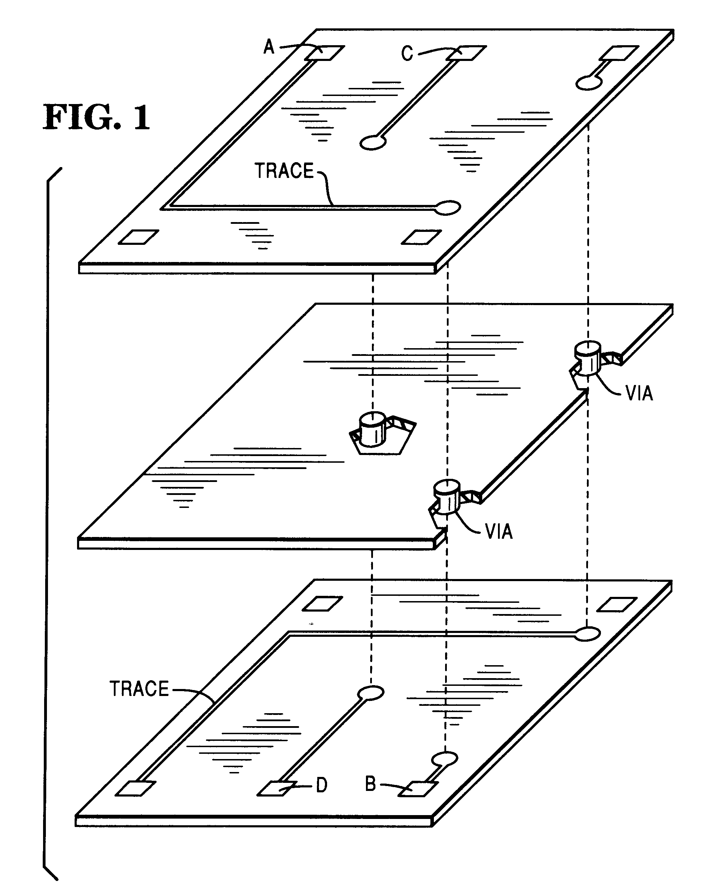

The type of connections formed is shown schematically in Figure 1. The TRACES cross over each other, by means of the VIAs: pad A connects with pad B, pad C with D, and so on. The traces form a 3-dimensional network, which is sometimes termed a "non-planar" network. The 3-dimensional network connects integrated circuits (not shown) with each other and with other connectors.

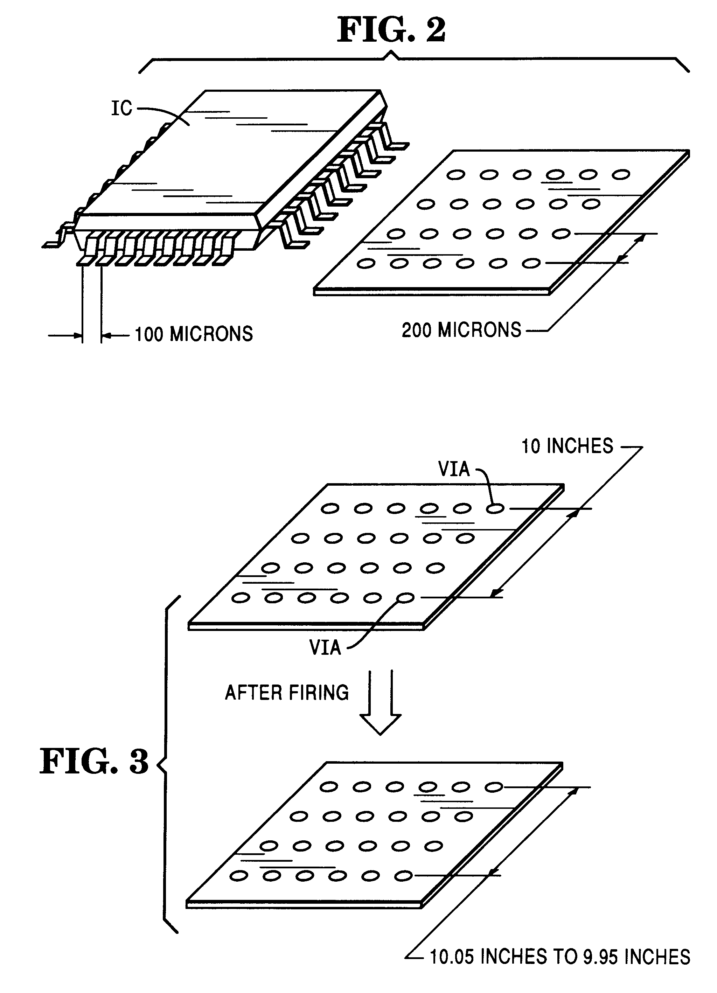

MCMs have numerous advantages, but also have limitations. One limitation is that the spacing between the holes (which contain the vias) is limited to about 200 microns, as indicated in Figure 2.

One reason for this spacing limitation is that the pins which punch the holes in which the vias reside cannot be positioned closer than about 200 microns. This 200-micron spacing causes problems when an integrated circuit having a smaller pin spacing, such as that shown in Figure 2, is to be attached.

A second problem is that the MCM experiences random size changes during the firing process. The MCM shrinks during firing about 15 or 20 percent, and each (shrunken) part varies from its fellow parts by 0.5 %: a size variation ranging from - 0.5 % to + 0.5 % occurs.

For example, if intended spacing between the VIAs indicated in Figure 3 is 254 millimetres (10 inches), then, after firing, the spacing will range from 253 to 255 millimetres (9.95 to 10.05 inches). This random variability limits the accuracy with which an integrated circuit can be mounted to the vias.

Another feature of MCMs is their cost. In large production runs, they can be quite inexpensive, because the cost of equipment, such as the die which punches the holes, can be amortized over thousands of MCMs produced. However, for small production runs, in the tens or hundreds, the amortized cost per MCM produced becomes prohibitively high.

It is an object of the present invention to provide an electrical connector of the kind specified which is inexpensive to manufacture.

According to one aspect of the present invention, there is provided a connector for connecting an integrated circuit to a receptacle, characterized by a base module have connector pins adapted to connect with said receptacle, said connector pins being electrically coupled by first coupling means to base pads provided on said base module; and an integrated circuit module having IC pads thereon adapted to contact IC pins provided on an integrated circuit, said IC pads being electrically coupled by second coupling means to further pads provided on said IC module which are larger than, and adapted to mate with respective base pads.

According to another aspect of the present invention, there is provided a method of manufacturing an electrical connector, characterized by the steps of: selecting a base module which includes an array of base pads, an array of connector pins and conductive leads coupling said connector pins to said base pads; and forming an integrated circuit module on said base module by forming a plurality of layers each having a plurality of conductive traces thereon and holes for vias therein, said IC module having further pads thereon which are larger than and mate with respective base pads, and also having IC pads thereon for contact pins provided on an integrated circuit.

One embodiment of the present invention will now be described by way of example, with reference to the accompanying drawings, in which:-

Figure 1 illustrates, in simplified schematic form, a three-dimensional network used in multi-chip modules.

Figure 2 illustrates an integrated circuit (IC) having a pin spacing of 100 microns and a pad spacing of 200 microns.

Figure 3 illustrates shrinkage or expansion which can occur during firing of a multi-chip module.

Figure 4A illustrates, in x-ray view, a simplified form of the invention.

Figure 4B illustrates, in unfolded view, three of the components of Figure 4A. Parts of Figure 4B are shown in Figures 5 and 6.

Figure 5 illustrates internal features of the BASE MODULE and the IC MODULE of Figure 4A.

Figure 6 illustrates how the IC LAYER mates to the IC MODULE.

Figures 7A and 7B illustrate the mismatch which can occur between the BASE PADs and the OVERLAPPING PADs of Figure 5.

Figure 8 illustrates how VIAs penetrate metal film layers in the IC MODULE.

Figure 9 illustrates formation of METAL TRACES.

Figure 10 shows a sheet of BASE MODULEs.

Figure 11 shows an IC MODULE carrying edge-connectors.

Figure 12 shows a cross-section of Figure 11.

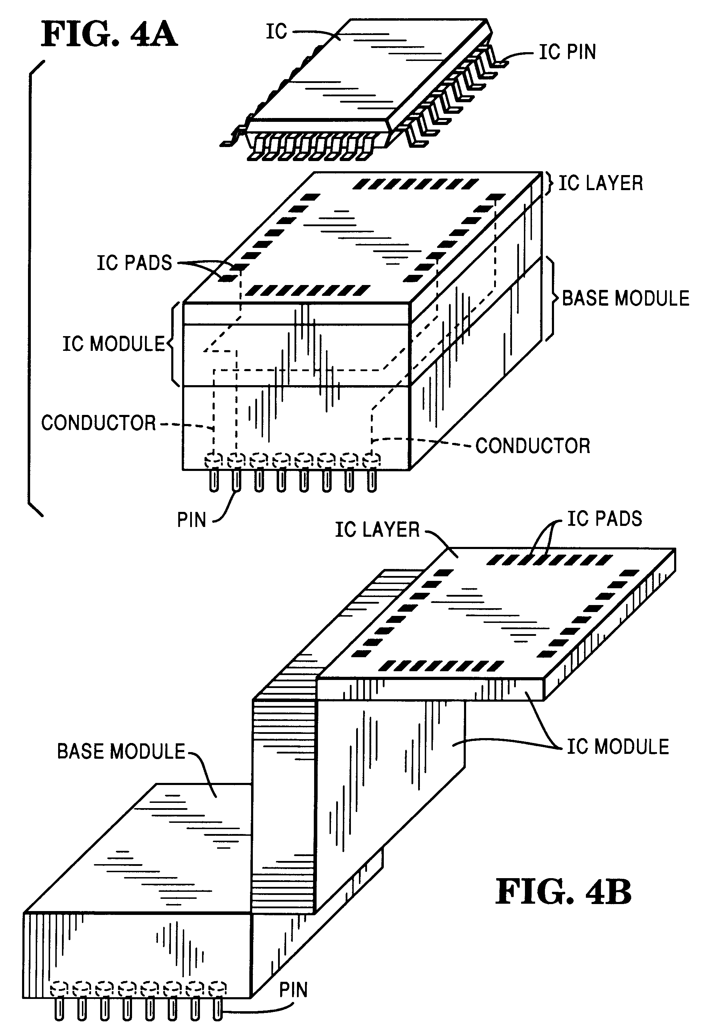

A simplified, X-ray view of one form of the invention is shown in Figure 4A. A BASE MODULE contains PINs for connection with a receptacle such as a socket (not shown). The BASE MODULE carries an IC MODULE, which, in turn, carries an integrated circuit, IC. Each PIN of the BASE MODULE connects with an IC PAD by way of a CONDUCTOR, shown dashed.

The BASE MODULE is a ceramic MCM. In practice, only a few BASE MODULES, each with a somewhat different routing pattern, are manufactured, because of their high cost. To assemble a connector, a BASE MODULE having a proper routing pattern of CONDUCTORs is selected from a collection of BASE MODULEs. Then, an IC MODULE is manufactured to accommodate the particular IC and the particular IC PAD-to-IC PIN connection desired. The IC MODULE is manufactured upon the BASE MODULE.

The IC MODULE is constructed of layers of polyimide material onto which conductive traces are formed using integrated circuit fabrication techniques.

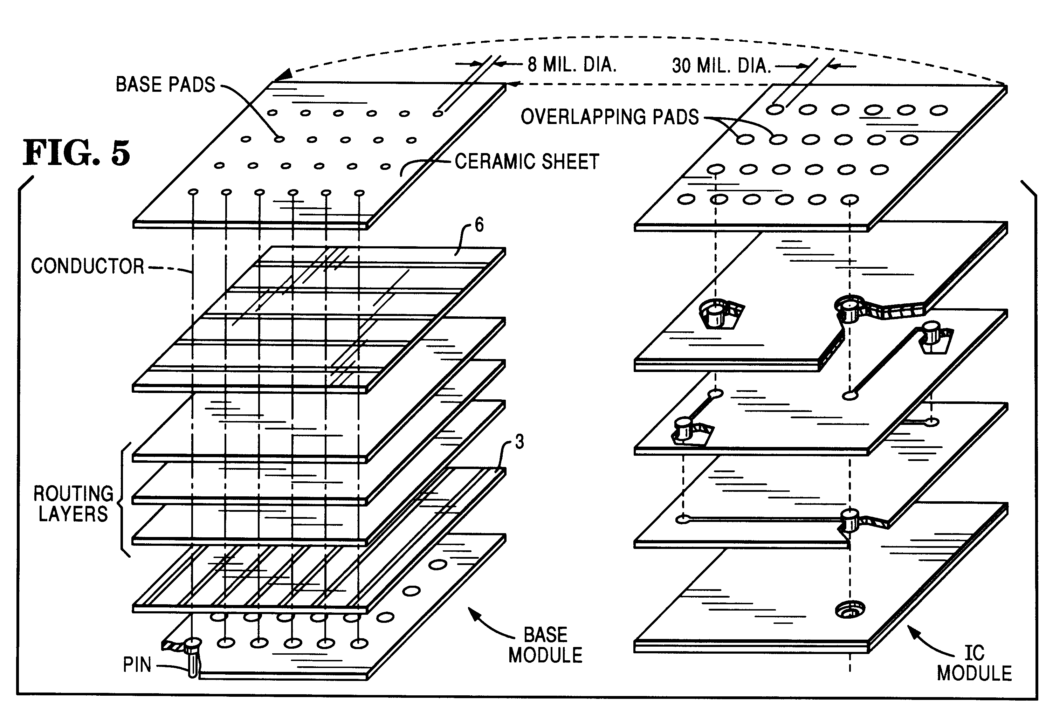

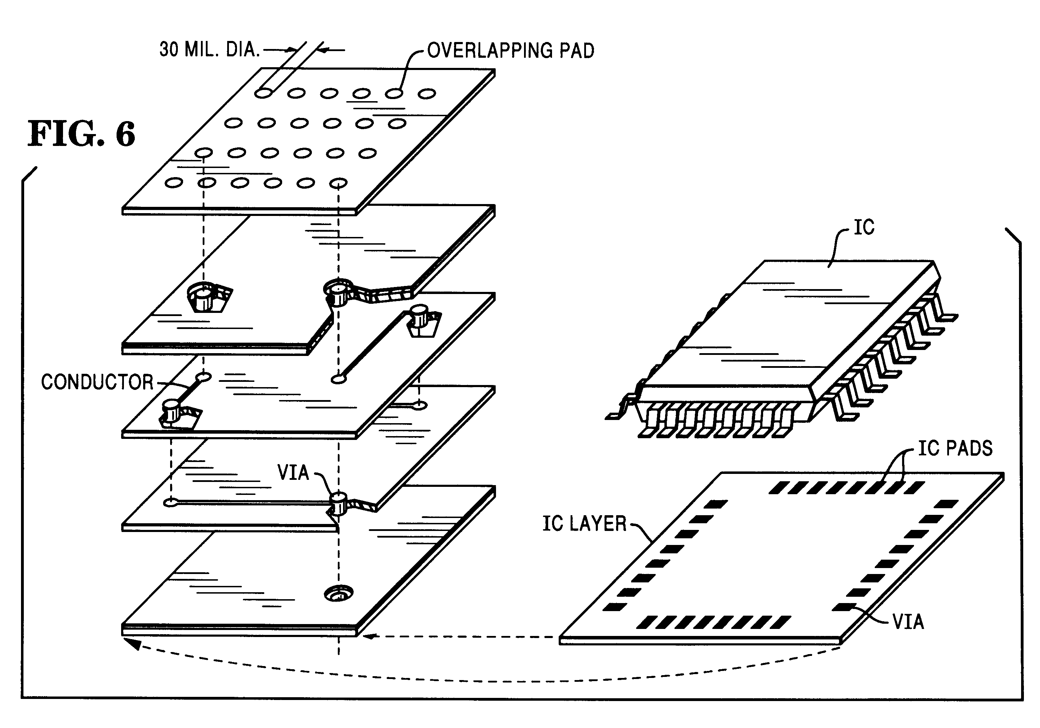

Figure 4B shows the connector of Figure 4A, but in an unfolded configuration which corresponds to the configurations shown in Figures 5 and 6. The unfolded configuration is used in order to show internal connections. As discussed herein, the IC MODULE is preferably not constructed as a separate element, which is then bonded to the BASE MODULE, but is manufactured upon the BASE MODULE, layer-by-layer.

In Figure 5, the PINs connect to BASE PADs by way of CONDUCTORs indicated by dashed lines. The BASE PADs are actually the ends of the vias which act as plugs within the holes in the CERAMIC SHEET. The CONDUCTORs shown make direct connections between the BASE PADs and the PINs: each CONDUCTOR follows a straight vertical path from a PIN to a BASE PAD. With this configuration, the ROUTING LAYERs may not be necessary, and can be omitted. (The ROUTING LAYERs perform the function shown in Figure 1: a selected PIN can be connected to a selected BASE PAD. Only three paths are shown for simplicity, but, in practice, hundreds, or thousands, of paths can be used.)

Layers 3 and 6 contain parallel conductors which act as power lines: on each layer, these conductors are all held at the same electrical potential. For example, layer 6 can be held at Vdd, and layer 3 at Vss. The conductors on layer 6 are orthogonal to those on layer 3. These layers carry power for the integrated circuits which will be carried by the IC MODULE. Layers 3 and 6 are not strictly necessary, and can be omitted in some situations.

The IC MODULE contains a network of CONDUCTORs and VIAs, shown in simplified form in Figure 6. The CONDUCTORs make contact with the BASE PADs (on the BASE MODULE) by means of OVERLAPPING PADS, shown in Figures 5 and 6. These OVERLAPPING PADs are larger than the BASE PADs, to accommodate the expansion and shrinkage, discussed hereinabove, which occurs in the BASE MODULE.

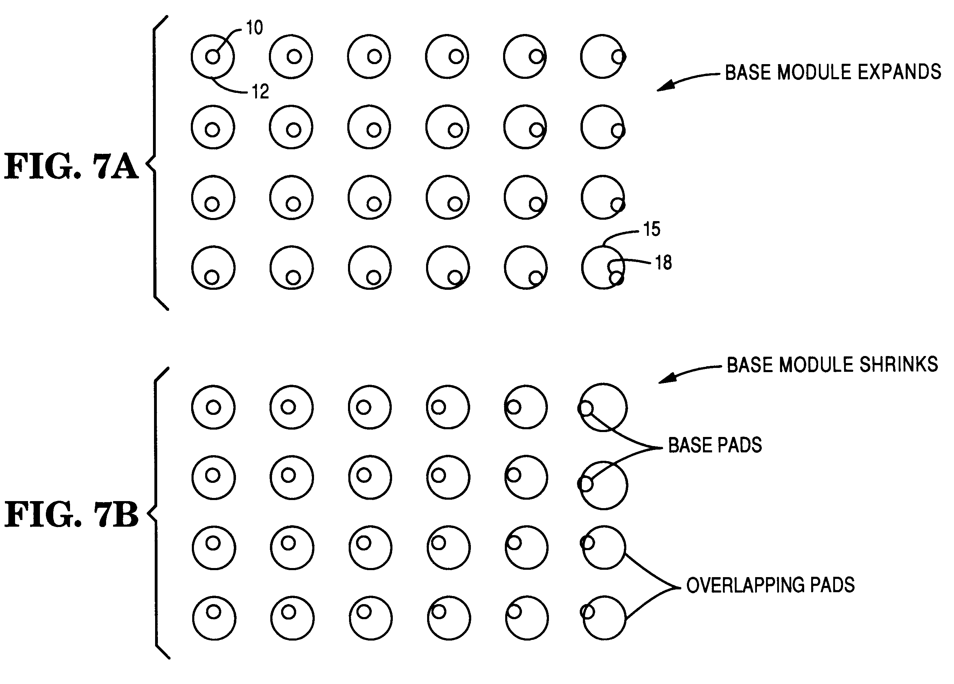

In one embodiment, the BASE PADs in Figure 5 are 203 microns (8 mils) in diameter, while the OVERLAPPING PADs are 762 microns (30 mils) in diameter. With these two sizes of the components, two types of contact between them are shown in Figure 7. In one type, shown in Figure 7A, the BASE MODULE expands by 0.5 percent. One OVERLAPPING PAD 12 (the larger circle) is centered on a BASE PAD 10. The rest are progressively off-center, and the maximal degree of off-centering occurs at the pair of pads 15 and 18 which is farthest from the centered pads 10 and 12. Thus, despite the expansion, all pairs of pads make good contact.

Similarly, if the BASE MODULE shrinks by 0.5 percent, the configuration is as shown in Figure 7B. For intermediate types of shrinkage or expansion, the type of contact will be intermediate between those shown in Figures 7A and 7B. It is of course recognized that the particular pair of pads which are centered will depend upon numerous factors, including the relative locations of the pads on their respective modules, and the degree of shrinkage or expansion. Further, in some situations, centering may not occur in any pair at all.

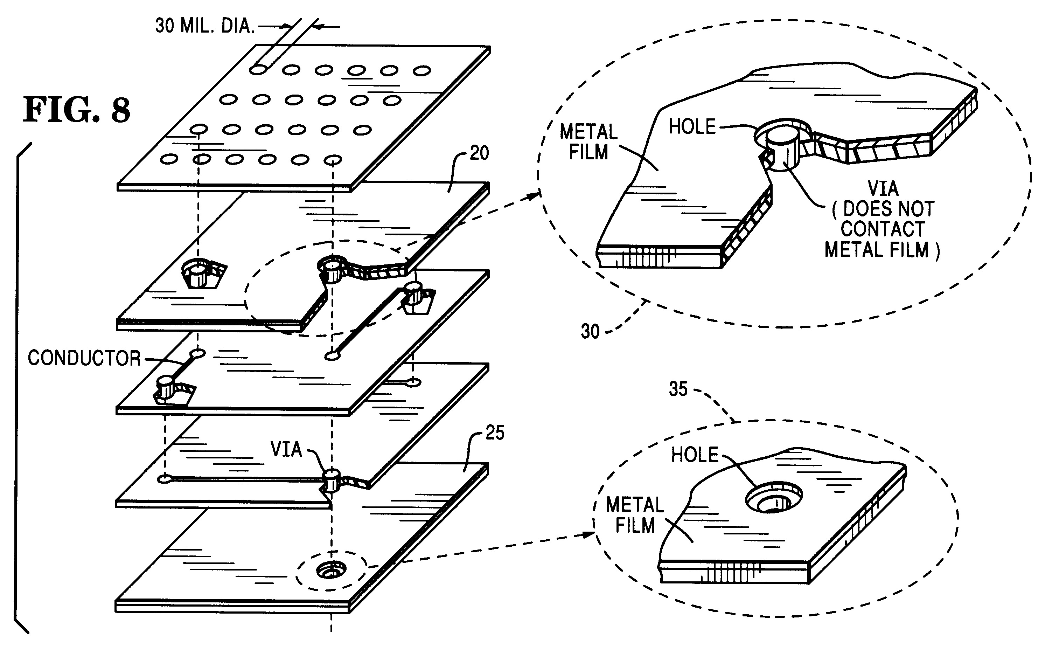

The OVERLAPPING PADs in Figure 6 are connected, by a three-dimensional network of VIAs and CONDUCTORs (or traces), to IC PADs on an IC layer. The VIAs penetrate, without contacting, two power planes, as shown in Figure 8. One plane is carried by layer 20, and the other is carried by layer 25. As shown in inserts 30 and 35, the VIAs, which form part of the network, do not contact the METAL FILM which forms the power planes. The VIAs pass through holes in the film, without making contact.

One METAL FILM is held at a high potential, such as Vdd, and the other METAL FILM is held at a low potential, such as Vss. There are conductors (not shown) running from the power planes in Figure 8 to selected IC PADs in Figure 6, for supplying power to the IC.

Several important features of the embodiment are discussed in the following paragraphs.

The layers forming the IC MODULE in Figure 5 are preferably a polyimide polymer, of typical thickness 10 - 25 microns. The polyimide layers are constructed by spinning the BASE MODULE on a centrifuge, and applying a liquid precursor, which centrifugal force spreads out into a thin layer. Upon curing, the thin layer becomes a polyimide layer. The CONDUCTORs (also called traces) in Figure 6 on the layers are formed using standard integrated circuit fabrication techniques.

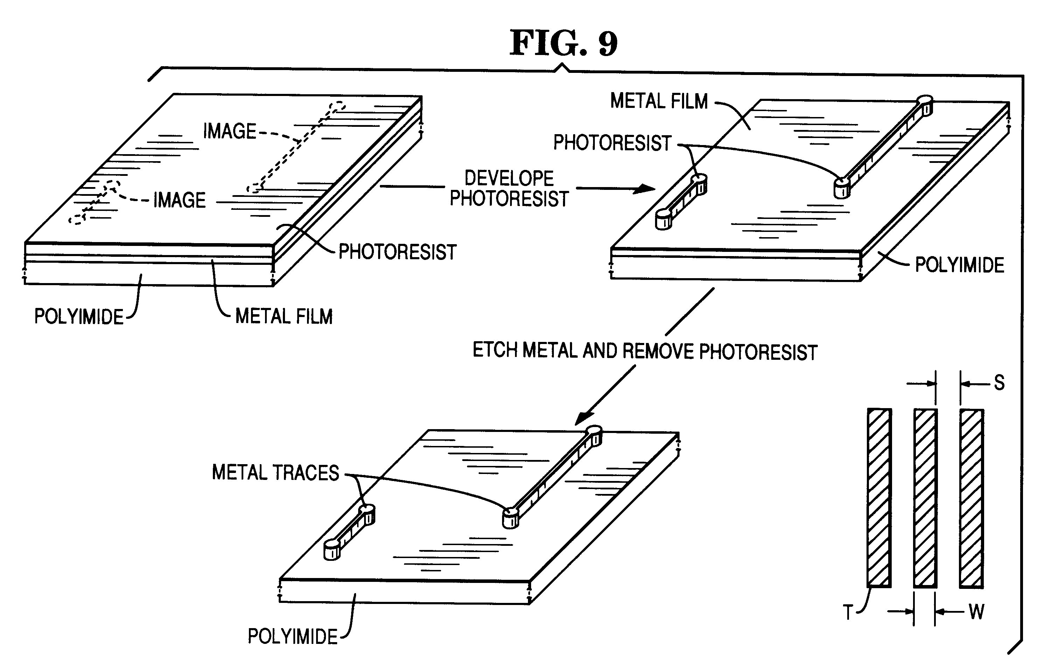

For example, as shown in Figure 9, to construct the traces, a layer of POLYIMIDE bearing a METAL FILM (preferably nickel), typically 1,000 Angstroms thick, provides an initial working material. PHOTORESIST is applied to the METAL FILM. An IMAGE is created on the PHOTORESIST, such as by contact printing or use of a projector. The PHOTORESIST is developed, as indicated, which leaves hardened PHOTORESIST at places where the METAL FILM is to be protected from etching.

The structure is subjected to an etchant, which removes the METAL FILM which is unprotected by the PHOTORESIST, leaving a pattern of METAL TRACES, as shown. The remaining, hardened, photoresist is removed from the METAL TRACES.

Techniques used in the fabrication of integrated circuits can produce metal traces T in Figure 9 having line widths W of the order of 10 - 30 microns, separated by a spacing S of 10 - 100 microns. These widths and spacings are exemplary; others are known in the art.

It should be noted that further processing of the METAL TRACES in Figure 9 can be desirable. A layer of copper, preferably about 5 to 10 microns thick, is plated onto the METAL TRACES. Then, another layer, preferably nickel, is plated onto the copper. The METAL TRACES thus become tri-layered: they contain three layers of metal. Such plating is known in the art. This plating increases the effective thickness of the METAL TRACES, allowing the plated traces to carry more current.

The plating is done to increase thickness, rather than attempting to produce thick METAL TRACEs initially, because it is difficult to etch thick METAL TRACES from a thick METAL FILM (in the range of between 5 and 10 microns). Further, it is difficult to etch small line widths in copper, but easier to plate existing lines using copper.

The second layer of nickel is applied to isolate the copper from the polyimide. If moisture should contact the polyimide in the presence of the copper, then corrosion can occur.

Another feature is that the IC LAYER in Figure 6 can contain IC PADs having a spacing smaller than the spacing between the BASE PADs in Figure 5. As mentioned above, BASE PADs are actually the tops of tungsten vias. These vias reside in the punched holes which were previously punched in the green ceramic tape during manufacture of the BASE MODULE. As stated above, the minimum spacing between the punched holes is typically limited to about 200 microns, as shown in Figure 2.

The spacing of the IC PADs in Figure 6 is limited by the fabrication technique used, which is different from that which limits the BASE PAD spacing. As indicated above, in connection with traces T in Figure 9, pad spacings of 50 microns (as opposed to 300 microns for the BASE PADs) can be attained using integrated circuit fabrication techniques. Prior-art technology used in manufacturing integrated circuits is capable of producing line widths W in Figure 9 of 10 microns, or less. This same technology can produce spacings S of 10 microns, or less. These spacings are less than twenty percent of the 300-micron spacing shown in Figure 2, which exists between the BASE PADs in the BASE MODULE.

One useful combination of spacings is 300 microns for the BASE PADs in Figure 5, and 100 microns for the IC PADs in Figure 6. The 203 micron (8-mil) vias are preferably on 305 micron (12-mil) centers.

As discussed in connection with Figure 7, The larger size of the OVERLAPPING PADs in Figures 5 and 6 accommodates the shrinkage of the MCM, which moves the BASE PADs relative to the OVERLAPPING PADs.

As noted above, the VIAs in Figure 6 in the IC MODULE are produced by masking and etching, as known in the integrated circuit fabrication art.

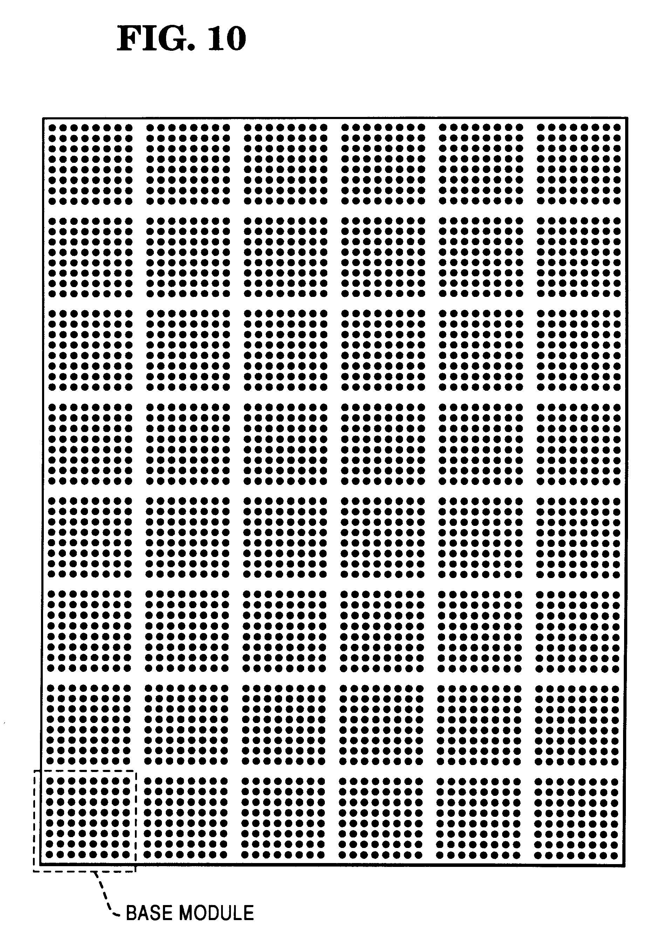

The BASE MODULES, shown in Figure 5, can be manufactured in large sheets, such as shown in Figure 10. Each module in the sheet has a connection pattern between its pins (concealed from view in Figure 10, but shown in Figure 5) and the BASE PADs (shown in Figure 10). For ease of manufacture, all BASE MODULES on a given sheet will have the same connection configuration.

When a BASE MODULE is needed, it is cut from its sheet. The IC MODULE is manufactured atop the base module, as described above.

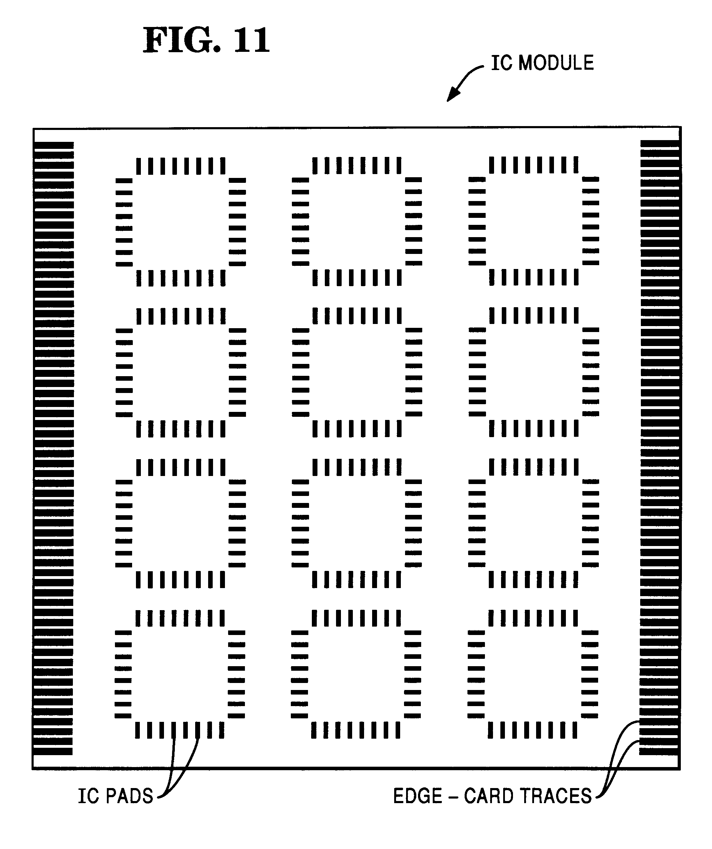

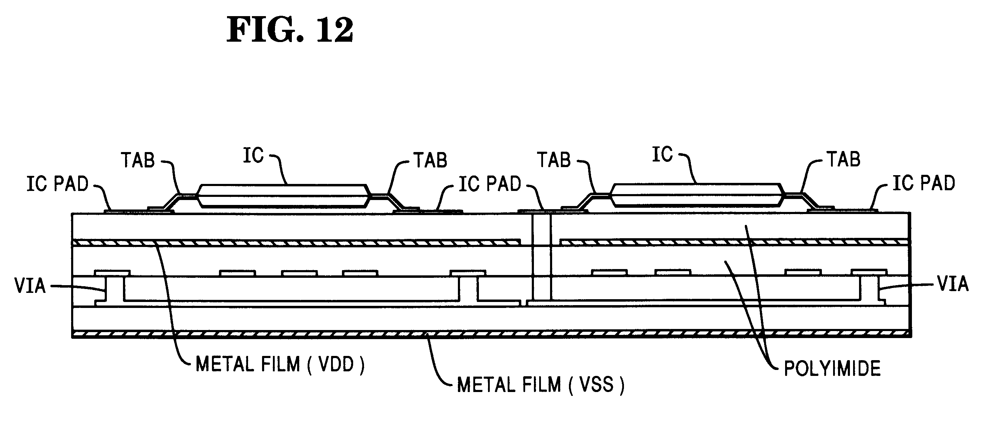

The PINs shown in Figure 5 are not strictly necessary. Instead, edge connectors can be used, as shown in Figure 11. A cross section is shown in Figure 12. The layers in the cross section are polyimide sheet. The top polyimide sheet can carry the edge-card traces shown in Figure 11.

It will be appreciated that the OVERLAPPING PADs in Figure 5 overlap the BASE PADs, not each other. The OVERLAPPING PADs may also be called "over-size" pads, because their cross-sectional areas exceed the minimal area necessary to carry the required current. The BASE PADs have at least this minimal area, and they are smaller than the oversize pads.

The center-to-center spacing between the BASE PADs in Figure 5 is also called their "pitch." The pitch shown in Figure 2 is a minimum of 300 microns. The pitch for the IC pins in that Figure is 100 microns.

As discussed above, because of the expansion or shrinkage of the BASE MODULE in Figure 5, the pitch of the BASE PADs can vary from 99.5% to 100.5% of the desired pitch. The BASE PAD pitch can thus be termed "random." It contains "random error." This does not mean that the pitch cannot be known: it can be ascertained by measurement. This does, however, mean that the pitch is not known in advance. That is, even if the pitch is known prior to firing of BASE PADs, nevertheless, after firing, the pitch becomes indeterminate.

Viewed another way, if 1,000 base modules are manufactured and thrown into a box, then, if one is selected, its pitch will not be known. The pitch will be random, within the 99.5 to 100.5 percent range.

Manufacture of an IC MODULE in Figure 5 having line spacings below 100 microns will probably take place in a class 100 clean room. Industry standards defining different classes of clean room are commercially available. In contrast, the BASE MODULE will probably not be manufactured in a clean room. One reason is that the punching operation will generate debris which a clean room will not tolerate.

The layers of METAL FILM in Figure 8 and the layers 3 and 6 of parallel traces in Figure 5, both of which supply power to the IC, act as electromagnetic shields for the conductors on the layers sandwiched between.

The designation TAB in Figure 13 refers to the standard Tape Automated Bonding technique used to attach the IC to the TAB frame. The TAB frame is welded to the IC pads using thermosonic bonding. For this reason, the top surface of the IC MODULE is gold-plated, to facilitate the thermosonic bonding, and for oxidation resistance.

## Claims

1. A connector for connecting an integrated circuit to a receptacle, characterized by a base module have connector pins adapted to connect with said receptacle, said connector pins being electrically coupled by first coupling means to base pads provided on said base module; and an integrated circuit (IC) module having IC pads thereon adapted to contact IC pins provided on an integrated circuit, said IC pads being electrically coupled by second coupling means to further pads provided on said IC module which are larger than, and adapted to mate with respective base pads.

2. A connector according to claim 1, characterized in that said base module is formed of a ceramic material and said IC module is formed of a polymer material.

3. A connector according to claim 2, characterized in that said polymer material is a polyimide polymer.

4. A connector according to claim 2 or claim 3, characterized in that said IC module includes a plurality of polymer layers having conductive traces formed thereon.

5. A connector according to claim 4, characterized in that said conductive traces are formed by multi-layer metallic strips.

6. A connector according to any one of the preceding claims, characterized in that said IC pads have a pitch spacing which is smaller than the pitch spacing of said base pads.

7. A method of manufacturing an electrical connector, characterized by the steps of: selecting a base module which includes an array of base pads, an array of connector pins and conductive leads coupling said connector pins to said base pads; and forming an integrated circuit (IC) module on said base module by forming a plurality of layers each having a plurality of conductive traces thereon and holes for vias therein, said IC module having further pads thereon which are larger than and mate with respective base pads, and also having IC pads thereon for contact pins provided on an integrated circuit.

8. A method according to claim 6, characterized in that said base module is formed of ceramic material and said IC module is formed of a polymer material by forming said plurality of layers of a polymer material.

9. A method according to claim 7, characterized in that said polymer material is a polyimide material.
